# EUROPEAN PATENT APPLICATION

(11) **EP 2 413 392 A2**
(43) Date of publication of application: **01.02.2012**
(21) Application number: 10756327.2
(22) Date of filing: 23.03.2010
(51) Int. Cl.: H01L 33/64, H01L 23/36

(54) **LIGHT-EMITTING DIODE PACKAGE**

(30) Priority: 24.03.2009 KR 20090024788
(71) Applicant: Kim, Kang, Gyeonggi-do 420-719 (KR)
(72) Inventor: Kim, Kang, Gyeonggi-do 420-719 (KR)
(74) Representative: Cabinet Plasseraud
(86) International application number: PCT/KR2010/001763
(87) International publication number: WO 2010/110572

(57) **Abstract**

A light emitting diode (LED) package is provided. The LED package includes: a package body including an LED; a bottom heat transfer metal layer formed on the bottom of the package body; and a metal plate bonded to the bottom heat transfer metal layer, wherein the bottom heat transfer metal layer is bonded to the metal plate through soldering or an adhesive such as Ag epoxy, and the metal plate includes only metal without a resin layer.

## Description

This application claims the benefit of Korea Patent Application No. 10-2009-0024788 filed on March 24, 2009, and PCT application No. PCT/KR2010/001763 filed on March 23, 2010, the entire contents of which are incorporated herein by reference for all purposes as if fully set forth herein.

### BACKGROUND OF THE INVENTION

### Field of the Invention

The present invention relates to a light emitting diode package having an improved heat dissipation path by directly connecting the light emitting diode package with a metal plate.

### Related Art

A light emitting diode (LED) is a two-terminal diode element including compound semiconductor materials such as GaAs, AlGaAs, GaN, InGaN, AlGaInP, or the like. The LED emits visible light with light energy generated according to recombination of electrons and holes when power is applied to a cathode terminal and an anode terminal.

A white LED emitting white light may be implemented through three-color combination of a red LED, a green LED, and a blue LED or by combining yellow phosphor to a blue LED. The advent of the white LED has extended the application fields of LEDs from the indicators of electronic products to daily products, advertisement panels, or the like, and currently, as LED chips have high efficiency, they are used to replace the general illumination light sources such as streetlights, vehicle head lamps, fluorescent lamps, or the like.

High-power, high-luminance LEDs are being applied to various lightings. The efficiency and life span of the LED are impaired as hotter heat is generated from a bonded surface of the LED. Thus, a design for releasing or dissipating heat generated from an LED chip is indispensable to the high-power, high luminance LED package.

Approximately 15% of energy applied to the LED package is converted into light, while approximately 85% of the energy is consumed as heat. An increase in the temperature of the LED chip increases a failure rate of the LED package.

As for a resin molding type LED package, low thermal conductivity of plastic resin hinders the provision of an efficient heat dissipation structure (or a heat sinking structure) in an LED chip of at least 0.2 W/mK. For this reason, the resin molding type LED package is being used for low luminance or an indicator utilizing an LED chip of below 0.1 watts. In order improve the heat dissipation structure of the resin molding type LED package, a package structure having a heat sink under the LED chip, being formed of copper (thermal conductivity 300 to 400 W/mK) or aluminum (thermal conductivity 150 to 180 W/mK), has been developed.

The resin molding type LED package having the heat sink achieves superior heat dissipation because heat is directly released through the heat sink metal, so it is applicable to an LED package of at least 0.1 watts. However, such a resin molding type LED package may experience cracking between a resin material and a metal core for a heat sink due to their different thermal expansion coefficients, thus causing a reliability issue.

In order to improve the heat dissipation structure, an LED package body formed of metal may be utilized. Materials of the package body may be aluminum, copper, or the like. This structure has excellent heat dissipation properties but may create a reliability issue, such as the oxidation of an electrode or the like which results from the infiltration of moisture or air since the difference in thermal expansion coefficient with transparent silicon or resin filled in a portion that emits light causes a gold wire for connection with an electrode surface of the LED chip to be cut or the interface between metal and silicon or resin is cracked.

As for an LED package utilizing ceramics as a material of a package body, the ceramics endow the LED package with high environmental resistance, a low thermal expansion coefficient, ultraviolet resistance, surface bonding performance with silicon, so the LED package may be used as an LED package requiring high reliability. The ceramic material may utilize alumina or low temperature co-fired ceramic (LTCC) material. The alumina having a thermal conductivity of between 15 W/mK and 20 W/mK, which is lower than that of metal, is suitable for an LED package of 0.2-watt to 1-watt grade, and the LTCC having a low thermal conductivity of 3 W/mK is inadequate for a high-power LED package. To improve this, there has been an attempt to improve heat releasing efficiency by forming a thermal via hole in an LED package and filling the thermal via hole with metal such as silver (Ag).

As for an array type LED package developed by Laminar Ceramics Inc. (USA), metal and ceramics having similar thermal expansion coefficients are co-fired, thus causing a ceramic layer to implement inter-electrode insulation, and an electrode and a circuit are designed on the ceramics so as to release heat, generated from an LED chip, through the metal, so the array type LED package realizes better heat dissipation performance. However, this LED package requires the selection of a high-priced special material in order to sinter heterogeneous ceramics and metal at the same time, and highly complicated process management is required, thus resulting in significantly high manufacturing costs.

In order to release heat of LED packages, a method of soldering the LED packages on a high-priced metal printed circuit board (PCB) or a thermal clad board is commonly used. In this case, heat generated from the LED packages is released through the metal PCB. The metal PCB has a structure in which a resin layer, a copper foil layer, a solder resist layer are stacked on an aluminum substrate. The resin layer serves to provide electrical insulation between the copper foil layer and the metal substrate thereunder, and to form a heat transmission path between the copper foil layer and the metal substrate. Heat generated from the LED package is subjected to first conduction through the copper foil layer of the metal PCB, and is then transmitted to the lower metal substrate through the resin layer. Therefore, in order to render the heat dissipation structure efficient, the resin layer needs to have increased thermal conductivity. The thermal conductivity of the resin layer used in the metal PCB ranges from approximately 1.0 W/mK to 2.2 W/mK. The metal PCB requires methods for coupling aluminum and copper foil facing each other with the resin layer therebetween, reliably bonding the two metals having different thermal expansion coefficients, and reducing stress between the two metals generated in bonding performance and thermal expansion. The thermal expansion coefficient of copper is approximately 17 ppm/K, and the thermal expansion coefficient of aluminum is approximately 25 ppm/K. In order to satisfy required performance in the resin layer of the metal PCB, the resin layer used in the metal PCB has a thickness of between approximately 0.075 mm to 0.30 mm, which is relatively thick. Such a thickness of the resin layer hinders a heat flow between the copper foil layer and the metal substrate in the metal PCB. Specifically speaking about a heat transmission in the metal PCB, heat generated from the LED chip is released along a heat transmission path by way of a package body of the LED package, and the solder layer, the copper foil layer, the resin layer, and the aluminum substrate of the metal PCB, and in this case, the resin layer has low thermal conduction, causing a bottle neck phenomenon of heat release in the thermal conduction flow.

When the LED packages are mounted in an array form on the metal PCB, the heat releasing effect only with the metal PCB has a low heat releasing effect, so a heat sink may be mounted on a lower surface of the metal PCB to release heat, and in this case, thermal grease, or the like, may be applied between the metal PCB and the heat sink in order to remove an air layer between the metal PCB and the heat sink. In this case, however, the thermal grease has thermal conductivity as low as about 2 to 3 W/mK, hindering a heat flow.

### Summary of the Invention

It is, therefore, an object of the present invention to provide an LED package capable of implementing a heat dissipation structure for enhancing LED efficiency and lengthening a life span at a low cost. Also, another object of the present invention is to provide a method for increasing the heat releasing efficiency of the LED package by improving a bonding method between the LED package and a metal plate (or a heat sink).

In an aspect of the present invention, a light emitting diode (LED) package includes: a package body including an LED; a bottom heat transfer metal layer formed on the bottom of the package body; and a metal plate bonded to the bottom heat transfer metal layer.

The bottom heat transfer metal layer is bonded to the metal plate through soldering or an adhesive such as Ag epoxy, and

The metal plate includes only metal without a resin layer.

In another aspect of the present invention, a light emitting diode (LED) package includes: a package body including an LED and a Zener diode; a heat transfer metal filler including metal filled through a via hole formed in a penetrative manner in the package body; and a metal plate bonded to the heat transfer metal filler, wherein the heat transfer metal filler is bonded to the metal plate through soldering or an adhesive such as Ag epoxy, and the metal plate includes only metal without a resin layer.

In another aspect of the present invention, a light emitting diode (LED) package includes: a package body including an LED and a Zener diode; a heat transfer metal filler including metal filled through a via hole formed in a penetrative manner in the package body; a bottom heat transfer metal layer formed on the bottom o the package body; and a metal plate bonded to the bottom heat transfer metal layer.

### Brief Description of the Drawings

The above and other objects and features of the present invention will become apparent from the following description of preferred embodiments given in conjunction with the accompanying drawings, in which:
FIG. 1 is a sectional view of an LED package according to a first embodiment of the present invention;
FIG. 2 is a plan view of the LED package illustrated in FIG. 1;
FIG. 3 is a bottom view of the LED package illustrated in FIG. 1;
FIG. 4 is a sectional view of an LED package according to a second embodiment of the present invention;
FIG. 5 is a sectional view of an LED package according to a third embodiment of the present invention;
FIG. 6 is a sectional view illustrating bonding between the LED package and illustrated in FIGS. 1, 4 and 5 and a heat sink;
FIGS. 7 and 8 are views illustrating circuit configuration examples of the LED package illustrated in FIGS. 1, 4 and 5;
FIG. 9 is a perspective view showing the exterior of an LED package according to a fourth embodiment of the present invention;
FIG. 10 is a sectional view of the LED package illustrated in FIG. 9;
FIG. 11 is an equivalent circuit diagram of an LED chip embedded in the LED package illustrated in FIG. 9;
FIG. 12 is a sectional view illustrating an example in which anode and cathode electrodes of the LED package in FIG. 9 are short-circuited when the LED package is soldered onto a metal plate in the LED package;
FIG. 13 is a sectional view showing an example in which the anode and cathode electrodes of the LED package are lifted in order to prevent such short-circuit as in FIG. 12;
FIG. 14 is a sectional view illustrating wire connection to the LED package as in FIG. 13;
FIG. 15 is a sectional view showing an example in which bonded portions of the electrodes and wirings of the LED package of FIG. 13 are coated with an insulating tape or an insulating tube;
FIG. 16 is a sectional view illustrating an example in which an insulating pad or an insulating sheet is attached to a metal plate on which the LED of FIG. 13 is bonded;
FIG. 17 is an equivalent circuit diagram illustrating the cause of an LED short circuit defect generated when the LED packages of FIG. 13 are attached together to a single metal plate;
FIG. 18 is a sectional view illustrating an example in which the LED packages of FIG. 13 are bonded to separated metal plates in a one-to-one manner and the LED packages are connected in series;
FIG. 19 is an equivalent circuit diagram of the LED packages connected in series as in FIG. 18; and
FIG. 20 is a sectional view illustrating an example in which a plurality of LED packages are connected in series on a single metal plate.

### Detailed Description of the Embodiments

In an LED package according to an embodiment of the present invention, soldering available metal is coated on the entirety of the bottom of a package body of an LED package and the bottom of the LED package is directly soldered to a low-priced metal plate (or a heat sink) to release heat generated from the LED chip through the soldered layer and the metal plate, thus increasing heat releasing efficiency. Here, the low-priced metal plate (or heat sink) includes only metal without a resin layer. A copper plate, or an aluminum plate having a surface nickel plated to allow for soldering may be used as the metal plate (heat sink). The solder material may contain 96.5% of tin (Sn), 3% of silver (Ag), and 0.5% of copper (Cu).

According to another embodiment of the present invention, the LED package is bonded to the low-priced metal plate without a resin layer by using an adhesive (or a bonder, or the like) or the like, such as Ag epoxy having a thermal conductivity of about 3 W/mK or the like. The Ag epoxy adhesive includes Ag powder added theretin, so it has relatively high thermal conductivity.

Since the bottom of the LED package is soldered to the metal plate (or a heat sink) or bonded to the metal plate through a thin resin layer, an anode electrode and a cathode electrode are formed on an upper portion of the LED package or bent to an upper side of the metal plate in order to prevent short circuit of the electrodes of the LED package through the metal plate. The metal plate may be used as a ground, and in this case, the bottom metal layer of the LED package may be connected to the anode electrode or the cathode electrode.

The LED package soldered to the metal plate may be provided with power from an external power source through a lead wiring or provided with power from an external power source through an FR4 (Flame Retardant composition 4) PCB having a circuit pattern and an lead wiring connected thereto.

Exemplary embodiments of the present invention will be described in detail with reference to the accompanying drawings. Throughout the specification, like reference numerals denote the like components. In describing the present invention, if a detailed explanation for a related known function or construction is considered to unnecessarily divert the gist of the present invention, such explanation has been omitted but would be understood by those skilled in the art.

The names of elements used in the description hereinafter may be selected in consideration of easiness of description of a specification and may be different from the names of the components of the actual product.

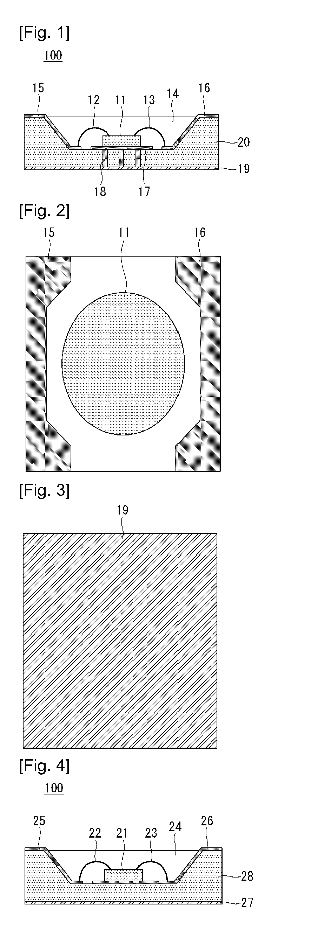

With reference to FIG. 1, an LED package 100 according to a first embodiment of the present invention includes a package body 20, an LED chip 11, gold wirings 12 and 13, an anode electrode 15, a cathode electrode 16, a resin layer 14, a top heat transfer metal layer 17, a bottom heat transfer metal layer 19, and a heat transfer metal filler 18.

The package body 20 may be made of a resin or a ceramic material. A recess is formed on an upper surface of the package body 20. The top heat transfer metal layer 17 is formed on the bottom of the recess, and the LED chip 11 is soldered on the top heat transfer metal layer 17. The top heat transfer metal layer 17 is formed between the anode electrode 15 and the cathode electrode 16, and spaced apart from the electrodes 15 and 16. An inner side wall of the package body 20 defining the recess includes sloped faces to enhance light reflection efficiency. The anode and cathode electrodes 15 and 16 are formed on the sloped faces, namely, on the upper portions of the package body 20. The anode electrode 15 may be connected to an anode of the LED chip 11 through the gold wiring 12. The cathode electrode 16 may be connected to a cathode of the LED chip 11 through the gold wiring 13. The resin layer 14 is buried in the recess at the upper side of the package body 20 to cover the LED chip 11, the top heat transfer metal layer 17, the gold wirings 12 and 13, or the like, to protect the elements from a physical impact or an infiltration of oxygen or moisture. The resin layer 14 may have a curved surface so as to serve as a lens.

One or more via holes penetrating the recess on the upper surface and the lower surface are formed and filled with the heat transfer metal filler 18. The heat transfer metal filler 18 may include nickel (Ni), silver (Ag), or an alloy thereof. The heat transfer metal filler 18 connects the top heat transfer metal layer 17 and the bottom heat transfer metal layer 19. The top heat transfer metal layer 17 and the bottom heat transfer metal layer 19 may have a structure in which any one of metal layers among nickel (Ni), copper (Cu), silver (Ag), and tin (Sn) is plated on any one of copper (Cu) electrode layer or a silver (Ag) electrode layer. The top heat transfer metal layer 17 may be connected to a ground terminal of the LED chip 11. The bottom heat transfer metal layer 19 may be bonded to the heat sink through soldering or an adhesive such as Ag epoxy or the like. The heat sink may be connected to a ground power source.

Heat generated from the LED chip 11 is released along a heat dissipation path including the LED chip 11, the top heat transfer metal layer 17, the heat transfer metal filler 18, and the bottom heat transfer metal layer 19.

FIG. 2 is a top plan view of the LED package 100. FIG. 3 is a bottom plan view of the LED package 100. The bottom heat transfer metal layer 19 is formed on the bottom of the package body 19 as in FIG. 3, thus enhancing the heat releasing efficiency of the LED package 100.

FIG. 4 is a sectional view of an LED package according to a second embodiment of the present invention.

With reference to FIG. 4, the LED package 100 according to the second embodiment of the present invention includes a package body 28, an LED chip 21, gold wirings 32 and 33, an anode electrode 25, a cathode electrode 26, a resin layer 24, and a bottom heat transfer metal layer 27. The anode electrode 25 and the cathode electrode 26 may be switched.

The package body 28 may be made of a resin or a ceramic material. A recess is formed on an upper surface of the package body 28. The anode electrode 25 and the cathode electrode 26 are formed on the bottom of the recess, and the LED chip 21 is formed on the cathode electrode 26. An inner side wall of the package body 20 defining the recess includes sloped faces to enhance light reflection efficiency. The anode electrode 25 and the cathode electrode 26 are elongated to the sloped faces and upper faces of the package body 28. The anode electrode 25 may be connected to an anode of the LED chip 21 through the gold wiring 22. The cathode electrode 26 may be connected to a cathode of the LED chip 21 through the gold wiring 23. The cathode electrode 26 extends to a portion under the LED chip 21. The resin layer 24 is buried in the recess at the upper side of the package body 28 to cover the LED chip 21, the gold wirings 22 and 23, or the like, to protect the elements from a physical impact or an infiltration of oxygen or moisture.

Unlike the embodiment of FIG. 1, in the embodiment of FIG. 4, a top heat transfer metal layer is not formed on the upper portion of the package body 28 and a via hole penetrating the package body 28 is not formed.

The bottom heat transfer metal layer 27 may have a structure in which any one of metal layers among nickel (Ni), copper (Cu), silver (Ag), and tin (Sn) is plated on any one of a copper (Cu) electrode layer and a silver (Ag) electrode layer. The bottom heat transfer metal layer 27 may be attached to a metal plate (or a heat sink) through any one of soldering, and an adhesive such as Ag epoxy. The metal plate may be connected to a ground power source.

Heat generated from the LED chip 21 is released along a heat releasing path including the LED chip 21, the cathode electrode 26, the package body 28, and the bottom heat transfer metal layer 27. The bottom heat transfer metal layer 27 is formed on the lower surface of the package body 28 as shown in FIG. 3 to thus increase the heat releasing efficiency of the LED package 100.

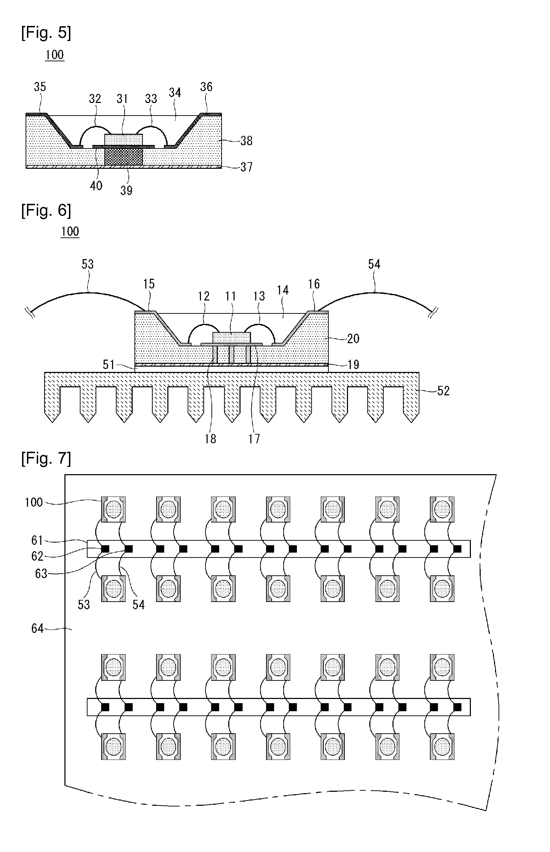

The LED package 100 of FIG. 4 is bonded to the metal plate 52 (or a heat sink) through soldering 51 as in FIG. 6.

FIG. 5 is a sectional view of an LED device according to a third embodiment of the present invention.

With reference to FIG. 5, the LED package 100 includes a package body 38, an LED chip 31, gold wirings 32 and 33, an anode electrode 35, a cathode electrode 36, a resin layer 34, a top heat transfer metal layer 40, a bottom heat transfer metal layer 37, and a heat transfer metal filler 39.The anode electrode 25 and the cathode electrode 36 may be switched.

The package body 38 may be made of a resin, or a ceramic material. A recess is formed on an upper surface of the package body 38. The anode electrode 35, the cathode electrode 36, and the top heat transfer metal layer 40 are formed on the bottom of the recess. The LED chip 31 is formed on the top heat transfer metal layer 40. The top heat transfer metal layer 40 is formed between the anode electrode 35 and the cathode electrode 36, and spaced apart from the electrodes 35 and 36 at a predetermined interval. An inner side wall of the package body 38 defining the recess includes sloped faces to enhance light reflection efficiency. The anode and cathode electrodes 35 and 36 are elongated to the sloped faces and the upper faces of the package body 38. The anode electrode 35 may be connected to an anode of the LED chip 31 through the gold wiring 32. The cathode electrode 36 may be connected to a cathode of the LED chip 31 through the gold wiring 33. The resin layer 34 is buried in the recess at the upper side of the package body 38 to cover the LED chip 31, the upper electrodes 35 and 36, the gold wirings 32 and 33, or the like, to protect the elements from a physical impact or an infiltration of oxygen or moisture.

A single via hole penetrating the recess on the upper surface and the lower surface is formed in the package body 28 and filled with the single heat transfer metal filler 39. Metal of the single heat transfer metal filler 39 may include one of metals among nickel (Ni), silver (Ag), or an alloy thereof. The single heat transfer metal filler 39 connects the top heat transfer metal layer 40 and the bottom heat transfer metal layer 37. The top heat transfer metal layer 40 and the bottom heat transfer metal layer 37 may have a structure in which any one of metal layers among nickel (Ni), copper (Cu), silver (Ag), and tin (Sn) is plated on a copper (Cu) electrode layer or a silver (Ag) electrode layer. The bottom heat transfer metal layer 37 may be connected to the metal plate (or a heat sink) through soldering, an adhesive such as Ag epoxy, or the like. The metal plate 60 may be connected to a ground power source.

The bottom heat transfer metal layer 37 may include a nickel layer-formed aluminum. One or more of gold (Au), silver (Ag), and copper (Cu) may be stacked on the nickel layer plated on aluminum. The bottom heat transfer metal layer 37 may be connected to the metal plate (or a heat sink) through soldering, an adhesive such as Ag epoxy, or the like.

Heat generated from the LED chip 31 is released along a heat releasing path including the LED chip 31, the top heat transfer metal layer 40, the single heat transfer metal filler 39, and the bottom heat transfer metal layer 37. The bottom heat transfer metal layer 37 is formed on the lower surface of the package body 38 as in FIG. 3 to thereby increase the heat releasing efficiency of the LED package 100.

The LED package of FIG. 5 is bonded to a low-priced metal plate (or a heat sink) 52 without a resin layer through soldering as in FIG. 6, and is provided with power from an external power source through lead wirings 53 and 54.

The low-priced metal plate (or a heat sink) 52 without a resin layer may be attached to the bottom heat transfer metal layer 19, formed on the lower surface of the LED package 100 illustrated in FIGS. 1 through 5, through soldering 51 as in FIG. 6. The metal plate 52 may be made of aluminum plated with any metal among copper (Cu), silver (Ag), gold (Au), and nickel (Ni) to allow the bottom heat transfer metal layers 19 and the metal plate 52 to be soldered. This is because the surface of copper (Cu), silver (Ag), gold (Au), and nickel (Ni) can be soldered while aluminum (Al) is not. The metal such as copper (Cu), silver (Ag), gold (Au), and nickel (Ni) may be plated on aluminum through electroless plating. Heat of the LED package 100 in FIG. 6 is released along a heat transfer path including the LED chip 11, the top heat transfer metal layer 17, the heat transfer metal filler 18, the bottom heat transfer metal layer 19, a soldering material (a material), and a metal plate (or a heat sink) 52.

In FIG. 6, reference numeral 53 denotes a positive lead wiring electrically connecting the anode electrode 15 of the LED package 100 to a printed circuit board (PCB), and reference numeral 54 denotes a negative lead wiring electrically connecting the cathode electrode 16 of the LED package 100 to the printed circuit board. An external power source supplies current to the LED chip 11 thorugh the printed circuit board (PCB), the lead wirings 53 and 54, the anode electrode 15, and the cathode electrode 16, and the gold wirings 12 and 13.

In FIG. 6, the LED package 100 and the heat sink 52 may be bonded together by an adhesive such as Ag epoxy or the like, instead of the soldering 51, although the heat releasing effect may be somewhat impaired.

FIG. 7 illustrates an example in which LED packages in the above embodiments are connected in the form of an array circuit.

As for a circuit configuration example in the case where the LED packages 100 are implemented as LED packages of 100 watts, the driving voltage of a blue LED chip is approximately 3.4 V, and in most cases, DC power of 12 V or 24 V is received through an adaptor converting AC power into DC power.

When DC power of 12 V is used and three LED packages 100 are connected in series, a resistor is used to adjust power to 10.2 V and adjust overcurrent flowing in the LED chip. Since the resistor needs to compensate for approximate 1.8 V which is the difference between 12 V and 10.2 V, the efficiency of current being supplied to the LED chip is impaired, and heat is also generated from the resistor, acting as load to a heat dissipation system.

If DC 24V is used and seven LED packages are connected in series as in FIG. 7, since DC voltage required for the serial circuit is 23.8 V, a low level of power is consumed by the resistor, thus reducing heat generated from the resistor.

An LED array of FIG. 7 includes a plurality of FR4 PCBs 61 having circuits for connecting LED packages 100 in series, and a metal plate 64 on which each of the LED packages 100 is bonded through soldering. Two LED rows are connected to a single FR4 PCB 61. Each of the LED rows includes seven LED packages 100. The LED packages 100 are connected to terminals 62 and 63 of the FR4 PCB 61 through the lead wirings 53 and 54. The FR4 PCB 61 is connected to an external power source of 24 V through a connector and a cable.

An LED chip included in each of the LED packages 100 of the LED array as in FIG. 7 is implemented into an LED chip of 2 watts. If the number of LED packages 100 of such an LED is 49, it may substitute an existing fluorescent lamp of 100 watts. The metal plate 64 may be implemented into a copper plate allowing for soldering, and an aluminum plate plated with metal such as silver (Ag), gold (Au), Nickel (Ni), or the like.

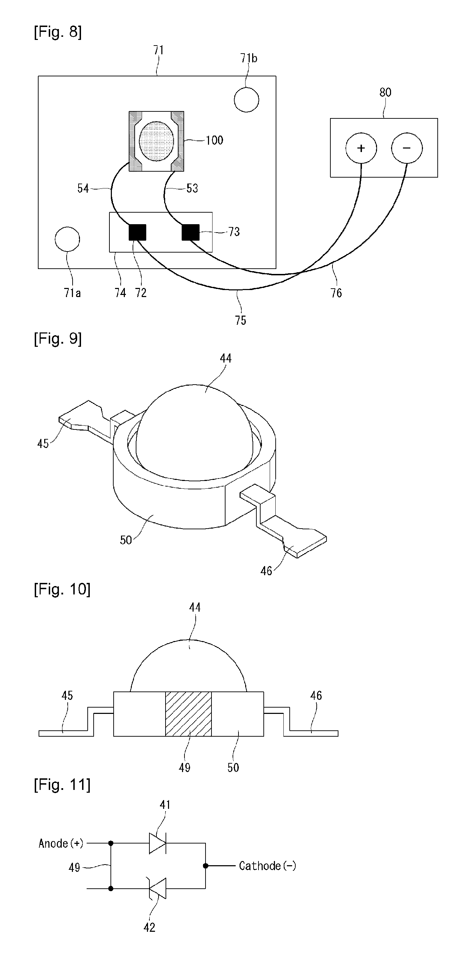

FIG. 8 illustrates an example in which the LED package is connected to an external power source.

With reference to FIG. 8, reveted join holes 71a and 71b are formed in a metal plate 71, and the LED package 100 and an FR4 PCB 74 are bonded together through soldering. The FR4 PCB 74 is provided with circuits and terminals 72 and 73 to connect the lead wirings 53 and 54 of the LED package 100 and the wirings 75 and 76 of an external power source 80. The metal plate 71 may be implemented into a copper plate allowing for soldering, or an aluminum plate plated with metal such as silver (Ag), gold (Au), Nickel (Ni) or the like.

FIG. 9 is a perspective view illustrating the exterior of an LED package according to a fourth embodiment of the present invention. FIG. 10 is a sectional view of the LED package illustrated in FIG. 9. FIG. 11 is an equivalent circuit diagram of an LED chip provided in the LED package illustrated in FIG. 9.

With reference to FIGS. 9 through 11, the LED package 100 according to a fourth embodiment of the present invention includes a package body 50, an anode electrode 45, a cathode electrode 46, a lens 44, and a heat transfer metal filler 49.

The package body 50 may be made of resin or a ceramic material. A recess is formed on the package body 50. The anode electrode 45 and the cathode 46 of an LED chip (not shown) in the recess protrude to the outside through the side surfaces of the package body 50. The anode electrode 45 is connected to an anode terminal of the LED chip. The cathode electrode 46 is connected to a cathode terminal of the LEC chip. The lens 44 is formed on the package body 50 to cover the LED chip to thus protect the LED chip from a physical impact or an infiltration of oxygen or moisture.

A via hole is formed in the package body 50 and is filled with metal of the heat transfer metal filler 49. The metal of the heat transfer metal filler 49 includes nickel (Ni), silver (Ag) or an alloy thereof.

The heat transfer metal filler 49 of the package body 50 may be directly bonded on a metal plate (or a heat sink) through soldering or an adhesive such as Ag epoxy. In another embodiment, a bottom heat transfer metal layer (not shown) separately formed on the bottom of the package body 50 to be connected to the heat transfer metal filler 49 may be attached to a metal plate (or a heat sink) through soldering or an adhesive such as Ag epoxy. The metal plate (or a heat sink) may be connected to a ground power source.

The LED chip of the LED package 100 according to the fourth embodiment of the present invention is connected to a Zener diode 42 through the heat transfer metal filler 49 as in FIG. 11. In FIG. 11, reference numeral 41 denotes an LED of the LED chip. The LED 41 and the Zener diode 42 are connected together through the heat transfer metal filler 49. An anode terminal of the LED 41 is connected to a cathode terminal of the Zener diode 42 through the heat transfer metal filler 49, and a cathode terminal of the LED 41 is connected to an anode terminal of the Zener diode 42.

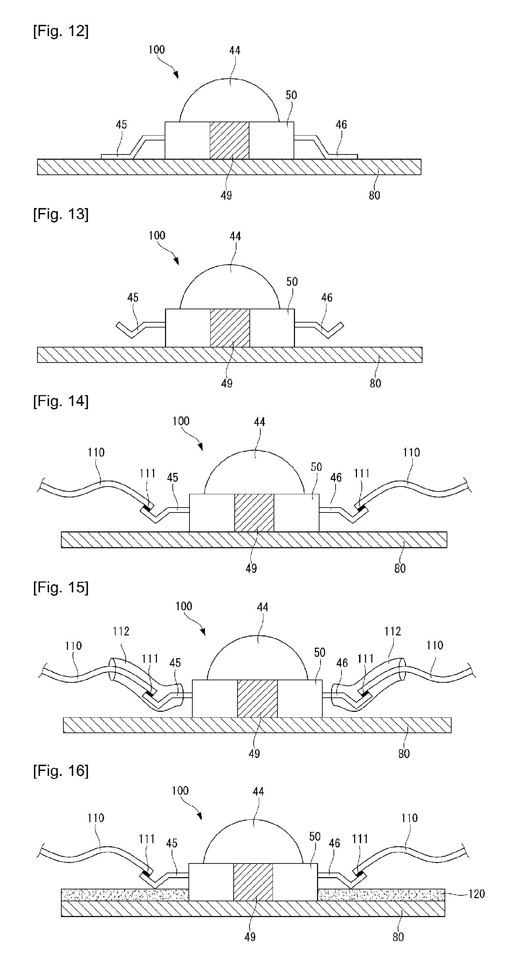

If the LED package 100 according to the fourth embodiment of the present invention, as shown in FIG. 12, is bonded to the metal plate 80 through soldering or through Ag epoxy as it is, the anode electrode 45 and the cathode electrode 46 of the LED package 100 come into contact with the metal plate 80, thus resulting in short-circuit between the anode electrode 45 and the cathode electrode 46. In this case, the anode voltage and the cathode voltage become equipotential, so the LED 41 fails to emit light. For this reason, the anode electrode 45 and the cathode electrode 46 of the LED package 100 are lifted as shown in FIG. 13 so as to be spaced apart from the metal plate 80.

In order to apply external power to the LED package 100 or connect it with another LED, the anode and cathode electrodes 45 and 46 of the LED package may be connected to wirings 110 through soldering 111 as shown in FIG. 14. In order to reliably insulate the electrodes 45 and 46 of the LED package 100 with the metal plate 80, the bonded portions of the electrodes 45 and 46 of the LED package 100 and the wirings 111 are coated with an insulating tape or an insulating tube (or a thermally contracted tube) as shown in FIG. 15, or an insulating pad or insulating sheet 120 may be bonded to the metal plate 80 as shown in FIG. 16. In this case, the insulating pad or insulating sheet 120 must be attached to the portions of the surface other than the bonded surface portion between the lower surface of the LED package 100 and the metal plate 80. The insulating pad or the insulating sheet 120 may be attached only to portions of the metal plate 80 facing the bonded portions of the electrodes 45 and 46 and the wirings 110. The insulating pad or insulating sheet 120 may be implemented as reflective sheets to increase illumination efficiency.

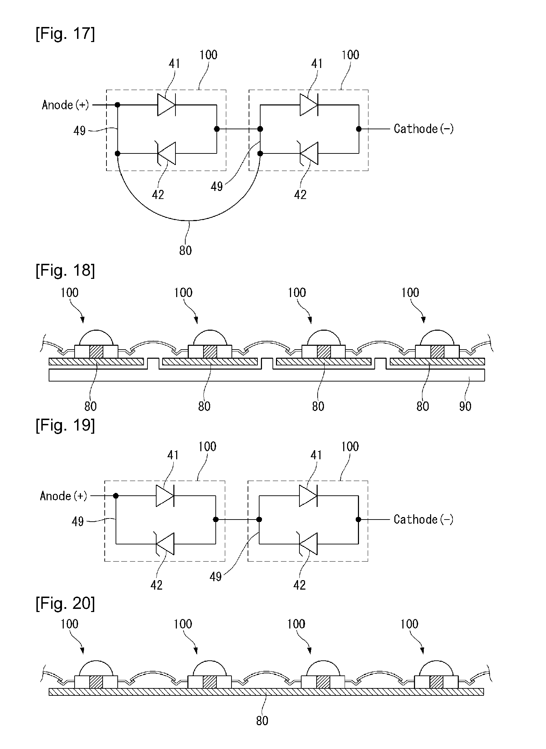

In the case of the LED packages 100 according to the fourth embodiment of the present invention, the plurality of LED packages 100 cannot be bonded to a single metal plate 60. This is because, when the first and second LED packages as shown in FIG. 17 are bonded to the single metal plate 80 through soldering or an adhesive such as Ag epoxy, the LED 41 and the Zener diode 42 are likely to be short-circuited through the metal filler 43 and the metal plate 80., and the voltages of the electrodes become equipotential. Thus, in the case of the LED package 100 as shown in FIG. 18, the LED packages 100 must be bonded to the separated metal plates 80 in a one-to-one manner. In FIG. 18, reference numeral 90 denotes an insulating frame supporting the metal plates 80 on which the LED packages 100 are bonded, respectively, and electrically separating the metal plates 80. Preferably, the insulating frame 90 is made of a material which is electrically an insulator and has high thermal conductivity. The LED packages 100 are connected in series through the wirings 110. FIG. 19 is an equivalent circuit diagram of the LED packages connected in series in FIG. 12.

The LED packages having the structure in which the LED and the Zener diode are not connected through the metal filler 43 and the heat transfer metal filler is connected to the anode and cathode terminals of the LED, can be bonded together on the single metal plate 80 as shown in FIG. 20. This is because, the plurality of LED packages 100 can be bonded to the metal plate 80 without a short-circuit problem.

As described above, according to the present invention, a metal plate without a resin layer is bonded to the lower surface of the LED package 100 such that heat from the LED package is released through the metal plate. Accordingly, the efficiency deterioration of the LED chip, and the shortening of the life span thereof, caused by heat, can be prevented to thus enhance reliability. More light can be obtained with the same consumption power as compared to the related art. This can allow for a reduction in the number of LED packages and heat sinks required for a lighting light source, as well as a reduction in manufacturing costs and the sliminess and compactness of a product. Furthermore, since low-priced metal plate and FR4 PCB are used instead of a high-priced metal PCB, the manufacturing costs of a lighting light source product can be further reduced.

The LED package 100 is applicable to any lighting light source described in the related art.

In all the embodiments of the present invention, the bottleneck phenomenon of the heat flow due to the resin layer formed in the existing metal PCB can be prevented, so the heat releasing effect can be maximized, and since the low-priced metal plates (or heat sinks, instead of the high-priced metal PCB, are used, the economical efficiency of various lighting devices using LEDs can be improved.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting diode (LED) package comprising:
a package body including an LED;
a bottom heat transfer metal layer formed on the bottom of the package body; and
a metal plate bonded to the bottom heat transfer metal layer,
wherein the bottom heat transfer metal layer is bonded to the metal plate through soldering or an adhesive such as Ag epoxy, and
wherein the metal plate comprises only metal without a resin layer.

2. The LED package of claim 1, wherein the bottom heat transfer metal layer has a structure in which any one of metal layers among nickel (Ni), copper (Cu), silver (Ag), and tin (Sn) is plated on a copper (Cu) electrode layer or a silver (Ag) electrode layer.

3. The LED package of claim 1, further comprising a heat transfer metal filler including metal filled through a via hole formed in a penetrative manner in the package body.

4. The LED package of claim 3, further comprising a top heat transfer metal layer installed within the package body such that the top heat transfer metal layer is formed below the LED chip including the LED,
wherein the top heat transfer metal layer is connected to the bottom heat transfer metal layer through the heat transfer metal filler.

5. The LED package of claim 1, wherein the package body further includes:
an anode electrode connected to an anode terminal of the LED; and
a cathode electrode connected to a cathode terminal of the LED,
wherein the cathode electrode and the anode electrode are formed on the upper surface of the package body.

6. The LED package of claim 1, wherein the LED package comprises a plurality of LED packages bonded to a single metal plate and connected in series.

7. A light emitting diode (LED) package comprising:
a package body including an LED and a Zener diode;
a heat transfer metal filler including metal filled through a via hole formed in a penetrative manner in the package body; and
a metal plate bonded to the heat transfer metal filler,
wherein the heat transfer metal filler is bonded to the metal plate through soldering or an adhesive such as Ag epoxy, and
wherein the metal plate includes only metal without a resin layer.

8. A light emitting diode (LED) package comprising:
a package body including an LED and a Zener diode;
a heat transfer metal filler including metal filled through a via hole formed in a penetrative manner in the package body;
a bottom heat transfer metal layer formed on the bottom o the package body; and
a metal plate bonded to the bottom heat transfer metal layer,
wherein the bottom heat transfer metal layer is bonded to the metal plate through soldering or an adhesive such as Ag epoxy, and
wherein the metal plate includes metal without a resin layer.

9. The LED package of claim 7 or 8, wherein the LED package is bonded to the metal plate in a one-to-one manner,
wherein a plurality of metal plates to which a plurality of LED packages are bonded in a one-to-one manner are separated to be insulated from each other, and the plurality of LED packages respectively bonded to the metal plates are connected in series, and
wherein the package body further includes an anode electrode connected to an anode terminal of the LED, and a cathode electrode connected to a cathode terminal of the LED, and
wherein the cathode electrode and the anode electrode protrude from side surfaces of the package body and are bent to be spaced apart from the metal plate.

10. The LED package of claim 7 or 8, wherein the package body further includes:
an anode electrode connected to an anode terminal of the LED; and
a cathode electrode connected to a cathode terminal of the LED,
wherein the cathode electrode and the anode electrode protrude from side surfaces of the package body and are bent so as to be spaced apart from the metal plate, and
wherein the electrodes and wirings are bonded through soldering, and bonded portions thereof are coated with an insulating body, or an insulating body is attached to a portion of the metal plate facing the bonded portions of the electrodes and the wirings.
